# EUROPÄISCHE PATENTSCHRIFT

(11) **EP 3 619 541 B1**
(45) Veröffentlichungstag und Bekanntmachung des Hinweises auf die Patenterteilung: **24.07.2024**
(21) Anmeldenummer: 18724178.1
(22) Anmeldetag: 04.05.2018
(51) Int. Cl.: G01R 1/067

(54) **VORRICHTUNG UND VERFAHREN ZUR KONTAKTIERUNG EINES ELEKTRONISCHEN ODER ELEKTRISCHEN SYSTEMS**
DEVICE AND METHOD FOR MAKING CONTACT WITH AN ELECTRONIC OR ELECTRIC SYSTEM
DISPOSITIF ET PROCÉDÉ POUR DE MISE EN CONTACT D'UN SYSTÈME ÉLECTRONIQUE OU ÉLECTRIQUE

(30) Priorität: 05.05.2017 DE 102017004336
(43) Veröffentlichungstag der Anmeldung: 11.03.2020
(73) Patentinhaber: Friedrich-Alexander-Universität Erlangen-Nürnberg, 91054 Erlangen (DE)
(72) Erfinder: GOLD, Gerald, 91054 Erlangen (DE); HELMREICH, Klaus, 90518 Altdorf (DE); LOMAKIN, Konstantin, 90411 Nürnberg (DE); SIPPEL, Mark, 90766 Fürth (DE)
(74) Vertreter: Herrmann, Uwe
(86) Internationale Anmeldenummer: PCT/EP2018/061516
(87) Internationale Veröffentlichungsnummer: WO 2018/202857

(56) Entgegenhaltungen:
- WO-A1-01/73451
- DE-A1- 102006 021 569
- JP-A- 2001 305 159
- JP-A- S6 221 065
- US-A- 5 175 493
- US-A1- 2013 002 238

## Beschreibung

Die vorliegende Erfindung betrifft eine Vorrichtung und ein Verfahren zur Kontaktierung eines elektronischen oder elektrischen Systems, insbesondere von Schaltungsträgern, wie z. B. Leiterplatten.

Aus dem Stand der Technik ist es bekannt, an Schaltungsträgern Hochfrequenz - Messungen (im Folgenden "HF-Messungen") durchzuführen, wobei zwei oder mehr als zwei Einzelkontakte in Form von Signal und Masse bzw. Innen- und Außenleiter einer Aufsetzstruktur des Schaltungsträgers elektrisch zu kontaktieren sind, die räumlich nahe beieinander liegen. Für präzise HF-Messungen muss die Aufsetzstruktur eine Ausgestaltung aufweisen, die sowohl an die HF-Eigenschaften der Messspitze als auch an die der Leiterplatte angepasst ist.

Die JP 2001 305159 A und die US 5 175 493 A offenbaren Messvorrichtungen und Verfahren zur Kontaktierung eines elektronischen oder elektrischen Systems.

Soll eine Automatisierung des Messvorgangs vorgenommen werden, besteht ein Problem darin, dass bekannte Messspitzen, die auf den Schaltungsträger aufgesetzt werden, um die HF-Messung durchzuführen, sehr teuer und mechanisch sehr empfindlich sind. Zum Kontaktieren des Schaltungsträges mit der Messspitze ist eine definierte Kraft notwendig: ist diese zu gering, folgt eine meist fehlerhafte Messung, ist diese zu groß, führt dies zu einer Zerstörung der Messspitze. Vor diesem Hintergrund ist eine Automatisierung der HF-Messung nur mit einem sehr großen technischen Aufwand möglich.

Als weitere Schwierigkeit kommt hinzu, dass die Automatisierung viele präzise Bewegungsachsen sowie zusätzlich häufig eine Bilderkennung und ggf. weitere Sensorik erfordert, was die Automatisierung teuer und zudem sehr langsam macht.

Ist der zu vermessende Schaltungsträger lokal uneben, werden die Einzelkontake der Messspitze unterschiedlich stark belastet, was bei zu geringer Kraft zu einem schlechten elektrischen Kontakt eines Einzelkontaktes und bei zu großer Kraft zu einer Beschädigung oder Zerstörung eines Einzelkontaktes der Messspitze führen kann. Eine Abhilfe bestünde darin, einen Neigungsausgleich der Messspitze vorzunehmen, was allerdings mit einem großen technischen Aufwand verbunden ist.

Aufsetzstrukturen unterliegen wie alle anderen Strukturen der Leiterplatte Fertigungstoleranzen. Will man gerade bzw. ebene Aufsetzstrukturen schaffen, unterliegen diese sehr hohen Anforderungen an die laterale Genauigkeit, so dass sich Fertigungstoleranzen besonders negativ auswirken. Abgesehen davon weisen Schaltungsträger häufig auch eine Unebenheit in Form einer Wölbung auf. Die sich daraus ergebende elastische Verformbarkeit wirkt sich auf die vertikale Aufsetzposition und Aufsetzkraft aus.

Ein weiteres Problem bei der Messung besteht darin, dass die notwendigen hochwertigen Messkabel, die die Messspitze mit dem Messgerät elektrisch verbinden, durch ihr Gewicht und mechanische Steifigkeit selbst Kräfte und Drehmomente ausüben. Dies hat zur Folge, dass eine korrekte Messung der Kraft, mit der die Messspitze die Aufsetzstruktur berührt, nur schwer durchführbar ist. Abgesehen davon wird das Messergebnis durch den Grad der Einhaltung der genauen Aufsetzposition erheblich beeinflusst, so dass auf die Messspitze einwirkende und durch das Kabel verursachte Kräfte und Momente störend wirken.

Schließlich besteht ein Problem bei Mehrtormessungen (gleichzeitige Messung an mehr als einer Aufsetzstruktur) darin, dass aufgrund der Wölbung und der Elastizität der Leiterplatte die Kontaktkräfte der einzelnen Messspitzen miteinander gekoppelt sind. Wird eine Messspitze aufgesetzt, kann es zu einer unzulässigen Kontaktkraft oder sogar zu einer Zerstörung einer bereits aufgesetzten Messspitze kommen.

Denkbar ist der Einsatz von Messspitzen bzw. Aufsetzstrukturen ohne Innen- bzw. Signalleiter, vorzugsweise in den Fällen, in denen keine Gleichstromkomponente mit übertragen werden muss.

Alternativ oder zusätzlich sind des Weiteren Messspitzen bzw. Aufsetzstrukturen denkbar, deren Außenleiter bzw. Leiter einen vollumfänglichen Aufsetzbereich aufweisen, beispielsweise für Anwendungen, bei denen das Signal in Innenlagen des Schaltungsträgers geführt wird.

Der vorliegenden Erfindung liegt die Aufgabe zugrunde, eine Vorrichtung und ein Verfahren bereitzustellen, mit dem eine schnelle und präzise Messung möglich ist.

Diese Aufgabe wird durch eine Vorrichtung mit den Merkmalen des Anspruchs 1 gelöst. Danach ist vorgesehen, dass die Messspitze wenigstens einen Außenleiter und wenigstens einen Innenleiter aufweist, der von dem Außenleiter umgeben ist, wobei sich zwischen dem Außenleiter und dem Innenleiter wenigstens ein Dielektrikum befindet und wobei die Messspitze wenigstens einen endseitigen Aufsetzbereich aufweist, mittels dessen die Messspitze auf eine Aufsetzstruktur eines elektronischen oder elektrischen Systems, insbesondere eines Schaltungsträgers, wie z.B. einer Leiterplatte aufsetzbar ist, wobei der Aufsetzbereich nur einen Teilbereich der endseitigen Fläche des Außenleiters umfasst.

Die Vorrichtung kann aus der Messspitze bestehen, so dass die Messspitze als solche unter Schutz gestellt ist. Die Vorrichtung kann ebenso die Messspitze sowie ein Messgerät umfassen, das über eine oder mehrere Kabel oder drahtlos mit der Messspitze in Verbindung steht und die erfassten Messwerte verarbeitet, anzeigt etc.

Erfindungsgemäß ist somit vorgesehen, dass der Aufsetzbereich nicht vollumfänglich, d.h. geschlossen ausgebildet ist, wie beispielsweise kreis- oder ringförmig, sondern nur teilkreisförmig. Ist der Außenleiter im Querschnitt beispielsweise kreisförmig, so wird der Aufsetzbereich der Messspitze nicht durch die vollständige stirnseitige, d.h. endseitige Fläche des Außenleiters gebildet, sondern nur durch einen Teilbereich von dieser Fläche.

Dies kann beispielsweise dadurch erreicht werden, dass im Endbereich des Außenleiters eine Stufenfräsung durchgeführt wird.

Durch die erfindungsgemäß mögliche Robustheit der Messspitze sind weit höhere Kontaktkräfte auf die Aufsetzstruktur möglich, als bei herkömmlichen Messspitzen. Somit sind störende Kraftwirkungen durch Messkabel und eine etwaige elastische oder plastische Verformung des Messobjekts, d.h. des Systems vernachlässigbar bzw. beeinträchtigen die Qualität der Messung nicht.

Erfindungsgemäß weist die Messspitze endseitig wenigstens einen vorspringenden und wenigstens einen demgegenüber zurückversetzten Abschnitt auf, wobei der vorspringende Abschnitt den Aufsetzbereich des Außenleiters darstellt.

Der Innenleiter der Messspitze bildet einen Bestandteil des Aufsetzbereiches der Messspitze. Somit kann zum Zwecke der Messung der Innenleiter auf die Aufsetzstruktur des Schaltungsträgers aufgesetzt werden oder auch von der Aufsetzstruktur beabstandet sein. Im letzten Fall kann sich zwischen dem Innenleiter und der Aufsetzstruktur ein Dielektrikum befinden.

Die Messspitze ist vorzugsweise koaxial ausgebildet, d.h. der Außenleiter und der Innenleiter sind koaxial zueinander angeordnet. Zwischen dem Außenleiter, der vorzugsweise die Masse darstellt, und dem Innenleiter, der vorzugsweise den Signalleiter darstellt, befindet sich vorzugsweise ein Dielektrikum, wie z.B. Luft oder ein Kunststoff, wie PTFE etc.

Die erfindungsgemäße Ausgestaltung der Messspitze erlaubt einen robusten Aufbau der Messspitze und somit auch deren Einsatz bei einer automatisierten Messung. Ein weiterer Vorteil besteht darin, dass die Qualität der Messung unempfindlich ist gegen eine laterale Fehlpositionierung der Messspitze.

Der Außenleiter kann beispielsweise rohrförmig ausgebildet sein und den Innenleiter vollumfänglich umgeben. Erfindungsgemäß bildet ein Teilbereich des stirnseitigen Endes des Außenleiters den Aufsetzbereich des Außenleiters.

Der Aufsetzbereich des Außenleiters ist erfindungsgemäß teilumfangförmig, insbesondere teilkreisförmig ausgeführt. Unter "teilumfangförmig" ist ein Teil eines geschlossenen Umfangs, wie einer Kreisstruktur, einer Ellipse, eines Quadrats, eines Rechtecks etc. zu verstehen.

Um eine besonders zuverlässige Kontaktierung der Messspitze zu erreichen, kann vorgesehen sein, dass der Aufsetzbereich der Messspitze mit wenigstens einem Leitelastomer und/oder mit einem oder mehreren Federkontaktelementen bzw. -stifen versehen ist. Ein solches Elastomer besteht vorzugsweise aus einem nicht leitenden Elastomermaterial, in dem leitendende Partikel eingebettet sind, die bei Übersteigen einer bestimmten Presskraft in Richtung der Presskraft, aber nicht in einer davon abweichenden Richtung eine leitende Verbindung herstellen.

Die vorliegende Erfindung betrifft des Weiteren ein elektronisches oder elektrisches System, insbesondere einen Schaltungsträger, wobei das System wenigstens eine Aufsetzstruktur aufweist, mit einer Messspitze einer Vorrichtung gemäß einem der Ansprüche 1 bis 4 zum Zwecke der Messung zusammenwirkt, wobei die Aufsetzstruktur wenigstens einen teilumfänglichen, vorzugsweise teilkreisförmigen Massebereich sowie wenigstens einen Signalleiter aufweist. Vorzugsweise ist der Signalleiter so angeordnet, dass dessen Ende im Zentrum des teilumfänglichen Massebereichs angeordnet ist.

Die Aufsetzstruktur kann mit wenigstens einem Leitelastomer versehen sein, wie dies bereits im Hinblick auf die Messspitze beschrieben wurde.

In einer denkbaren Ausgestaltung der Erfindung ist vorgesehen, dass das System und/oder dessen Aufsetzstruktur nicht planar, sondern uneben ist.

Denkbar ist es beispielsweise, dass das System durch das lagenfreie Erzeugen wenigstens einer räumlichen Struktur unter Verwendung wenigstens eines additiven und/oder abrasiven Verfahrens hergestellt ist. Durch die vorliegende Erfindung ist es möglich, während des Herstellprozesses und vorzugsweise automatisiert, Messungen an dem Schaltungsträger vorzunehmen und bei Feststellung eines Fehlers umgehend zu reagieren und ein fehlerhaftes Teil auszutauschen, bevor der gesamte Schaltungsträger fertig gestellt ist.

Die vorliegende Erfindung ist nicht nur bei planaren Systemen, sondern auch bei räumlichen Systemen, wie dreidimensionalen Schaltungsträgern vorteilhaft einsetzbar.

Die vorliegende Erfindung betrifft des Weiteren ein Verfahren zur vorzugsweise automatisierten Positionierung und Kontaktierung eines elektronischen oder elektrischen Systems, insbesondere eines Schaltungsträgers, mit einer Messspitze zur Durchführung einer Messung, insbesondere einer HF-Messung, wobei der Schaltungsträger wenigstens eine Aufsetzstruktur aufweist, auf die die Messspitze aufzusetzen ist, wobei das Verfahren den Schritt der lateralen Feinpositionierung der Messspitze durch Messung wenigstens eines Parameters an unterschiedlichen Positionen der Messspitze relativ zu der Aufsetzstruktur sowie die Ermittlung einer lateralen Zielposition umfasst, an der der Parameter einen geeigneten und vorzugsweise einen optimalen Wert annimmt, und wobei das Verfahren des Weiteren den Schritt des Aufsetzens oder des Verbleibens der Messspitze auf die/der Aufsetzstruktur in der Zielposition der Messspitze umfasst.

Das Auffinden der Zielposition, in der die Messspitze zur eigentlichen Messung des Schaltungsträgers oder eines Teils von diesem positioniert wird, kann somit kontaktlos erfolgen oder durch wiederholtes Aufsetzen der Messspitze auf der Aufsetzstruktur. In beiden Fällen kann durch Messung wenigstens eines Parameters ermittelt werden, an welcher Position sich ein zulässiger Wert des Parameters oder ein Optimum des Parameterwertes ergibt und diese Position dann als Zielposition festgelegt werden. Sobald die Zielposition ermittelt ist, verbleibt die Messspitze in ihrer aufgesetzten Position bzw. wird im Falle einer kontaktlosen Messung unter exakter oder weitgehend exakter Beibehaltung der lateralen Zielposition auf die Aufsetzstruktur aufgesetzt.

Bei dem Parameter kann es sich um einen beliebigen geeigneten, vorzugsweise elektrischen Parameter, wie z.B. um die Phase oder um wenigstens einen Streuparameter oder um einen daraus abgeleiteten Parameter eines gemessenen Signals handeln.

Vorzugsweise erfolgt die Messung des fraglichen Parameters durch die Messspitze bzw. durch die erfindungsgemäße Vorrichtung selbst, so dass keine weiteren Mittel zum Auffinden der Zielposition erforderlich sind.

Vorzugsweise wird bei der Durchführung des Verfahrens zur lateralen Positionierung weder von bildgebenden Verfahren noch von Sensoren Gebrauch gemacht. Vielmehr wird vorzugsweise der mittels der Messspitze ermittelte Wert genutzt, um die laterale Zielposition zu ermitteln.

Bei der Messung kann es sich um eine elektrische Nahfeldmessung vor dem Aufsetzen der Messspitze handeln oder das Verfahren kann das wiederholte Aufsetzen der Messspitze und das Messen des Parameterwertes z.B. durch Reflektometrie bei aufgesetzter Messspitze umfassen, wie dies vorstehend ausgeführt ist.

Grundsätzlich kann die Messspitze so ausgebildet sein, dass sie geeignet ist, elektromagnetische Wellen zu führen.

Weiterhin kann grundsätzlich vorgesehen sein, dass die Messspitze als dielektrischer Wellenleiter oder als Hohlleiter oder als Mehrleiteranordnung ausgebildet ist.

Die genannte Mehrleiteranordnung kann einen oder mehrere Signalleiter und einen oder mehrere Masseleiter umfassen oder aus diesen bestehen.

Es handelt sich bei der Messspitze um die Messspitze einer Vorrichtung gemäß einem der Ansprüche 1 bis 4 und/oder bei dem System um ein elektronisches oder elektrisches System nach einem der Ansprüche 5 bis 7.

Die vorliegende Erfindung betrifft des Weiteren ein Verfahren zur vorzugweise automatischen Kontaktierung eines elektronischen oder elektrischen Systems, insbesondere eines Schaltungsträgers, mit einer Messspitze zur Durchführung einer Messung, insbesondere einer HF-Messung, wobei der Schaltungsträger wenigstens eine Aufsetzstruktur aufweist, auf die die Messspitze aufzusetzen ist, wobei das Verfahren den Schritt der Messung der Kraft umfasst, mit der die Messspitze die Aufsetzstruktur kontaktiert, wobei die Messung durch wenigstens eine Messvorrichtung vorgenommen wird, die sich zwischen dem System und wenigstens einer Systemaufnahme, wie z.B. einem Träger befindet, auf der/dem das System angeordnet ist. Gemessen wird somit die Kontaktkraft zwischen dem System, z.B. zwischen dem Schaltungsträger, und dessen Auflage. Diese Kraft entspricht bis auf die Gewichtskraft der Kraft, mit der die Messspitze auf die Aufsetzstruktur des Systems gedrückt wird.

Vorzugsweise sind mindestens drei Messvorrichtungen, insbesondere Kraftsensoren sowie mehrere Aufsetzstrukturen des Schaltungsträgers vorgesehen, wobei zumindest eine Recheneinheit vorgesehen ist, die aus den durch die Messvorrichtungen gemessenen Werten sowie aus den bekannten Positionen der Aufsetzstrukturen die Einzelkräfte bestimmt, mit denen die einzelnen Messspitzen die jeweilige Aufsetzstruktur kontaktieren. Somit sind die Einzelkräfte messbar und einstellbar, mit denen die einzelnen Messspitzen auf die zugehörige Aufsetzstruktur einwirken. Dadurch ist eine Messung an mehreren Aufsetzstrukturen, d.h. Messstellen gleichzeitig möglich, wobei an jeder Messstelle die optimale Kraft mess- und einstellbar ist, mit der die Messspitze auf das System einwirkt.

An dieser Stelle wird darauf hingewiesen, dass die Begriffe "ein" und "eine" nicht zwingend auf genau eines der fraglichen Elemente verweisen, wenngleich auch dies von der Erfindung umfasst ist, sondern auch eine Mehrzahl der fraglichen Elemente mit umfassen. Ebenso ist darauf hinzuweisen, dass die Verwendung der Mehrzahl eines Elementes auch das Vorhandensein von nur genau einem Element mit einschließt und umgekehrt die Verwendung des Singulars bzgl. des Elementes auch eine Mehrzahl dieser Elemente mit umfasst.

Die Merkmale der Ansprüche der vorliegenden Erfindung können einzelnen oder auch kombiniert zur Anwendung kommen. Beide Fälle sind von der Erfindung umfasst. So kann beispielsweise das Positionierverfahren gemäß einem der Ansprüche 8 bis 12 zeitgleich, vor oder im Anschluss an ein Verfahren nach einem der Ansprüche 13 oder 14 durchgeführt werden.

Die vorliegende Erfindung betrifft des Weiteren eine Vorrichtung, die geeignet ist, das Verfahren gemäß einem der Ansprüche 8 bis 14 vorzugsweise automatisiert und besonders bevorzugt vollautomatisch durchzuführen. Dazu kann die Vorrichtung eine Halterung für die Messspitze sowie Verfahrmittel zum lateralen und vertikalen Verfahren der Messspitze aufweisen. Ist die Zielposition erreicht, die durch eine geeignete Messvorrichtung ermittelt wurde, wird die Messspitze mit Hilfe der Verfahrmittel auf die Aufsetzstruktur aufgesetzt und vorzugsweise dort gehalten, bis die Messung, insbesondere die HF-Messung abgeschlossen ist.

Weitere Einzelheiten und Vorteile der Erfindung werden anhand eines in der Zeichnung dargestellten Ausführungsbeispiels näher erläutert.

Es zeigen:
- Figur 1:: eine perspektivische Ansicht des Aufsetzbereichs der Messspitze,
- Figur 2:: eine Seitenansicht der Messspitze mit Leitelastomer,
- Figur 3:: Seitenansichten der auf das Prüfobjekt aufgesetzten Messspitze in unterschiedlichen Anwendungssituationen,
- Figur 4:: eine Draufsicht auf eine Aufsetzstruktur des Prüfobjekts.

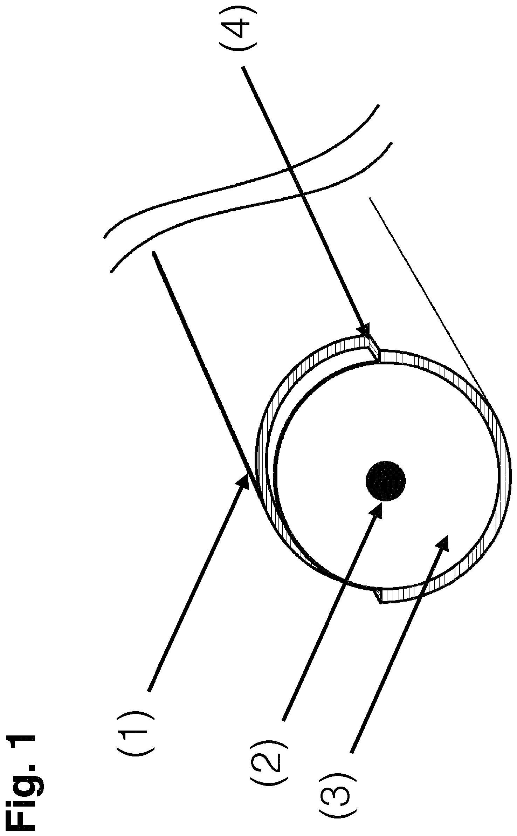

Figur 1 zeigt eine Messspitze einer Vorrichtung zur Vornahme von HF-Messungen an einem elektrischen oder elektronischen System, insbesondere an einem Schaltungsträger, wie z.B. an einer Leiterplatte, das im Rahmen der Erfindung auch als Prüfobjekt bezeichnet wird.

Die Messspitze ist koaxial aufgebaut und weist einen außenliegenden Außenleiter 1 (Masse) auf sowie einen innenliegenden, von dem Außenleiter 1 umgebenen Innenleiter 2 (Signalleitung).

Der Außenleiter 1 und der Innenleiter 2 stehen nicht miteinander in Kontakt und sind durch ein Dielektrikum 3, wie z.B. Luft, PTFE etc. voneinander getrennt.

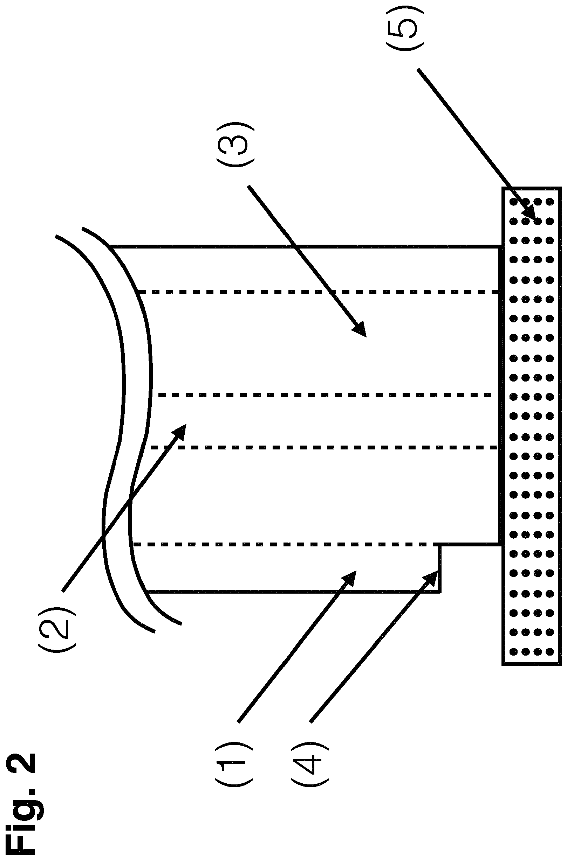

Wie dies aus Figur 1 und auch aus der Seitenansicht gemäß Figur 2 hervorgeht, ist der dargestellte endseitige Bereich der Messspitze gestuft ausgeführt, d.h. weist zwei Stufen 4 auf, so dass ein Abschnitt des endseitigen Bereichs hervorsteht und an ein anderer Abschnitt des endseitigen Bereichs demgegenüber zurückversetzt ist. Dieses gestufte Profil kann beispielsweise durch eine Fräsung oder dergleichen erhalten werden.

Wie dies insbesondere aus Figur 2 hervorgeht, bildet nur der hervorstehende endseitige Bereich den Aufsetzbereich der Messspitze, d.h. den Bereich mit dem der Außenleiter der Messspitze auf die Aufsetzstruktur des Prüfobjekts aufgesetzt wird bzw. mit einem Leitelastomer zusammenwirkt. Der zurückversetzte Bereich kommt hingegen bei der Messung nicht mit dem Prüfobjekt in Kontakt.

Somit steht beim Messvorgang nur der hervorstehende endseitige Bereich des Außenleiters 1 sowie der Innenleiter 2 mit der Aufsetzstruktur in Verbindung.

In dem hier dargestellten Ausführungsbeispiel ist der Aufsetzbereich des Außenleiters 1 teilkreisförmig ausgebildet. Er kann jedoch auch jede beliebige andere teilumfangförmige Form annehmen, worunter zu verstehen ist, dass der Aufsetzbereich einen Teilbereich einer geschlossenen Struktur, wie beispielsweise eines Kreises, einer ringförmigen Struktur, einer Ellipse, eines Polygons, eines Rechtecks etc. darstellt.

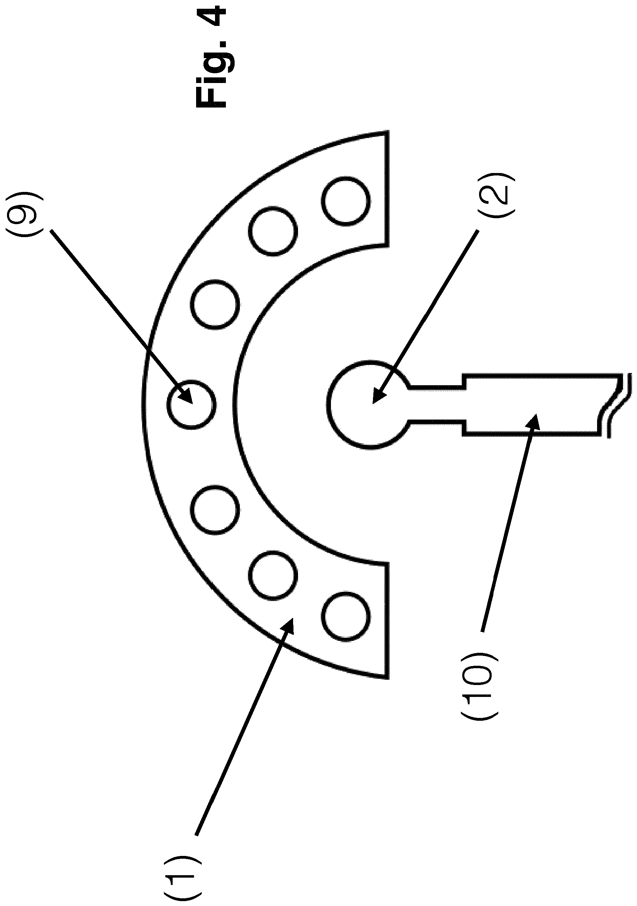

Die Messspitze gemäß Figur 1 wird auf eine Aufsetzstruktur des Schaltungsträgers gemäß Figur 4 aufgesetzt, wobei der Außenleiter 1 mit seinem Aufsetzbereich mit der Masse 9 der Aufsetzstruktur und der Innenleiter 2 mit der Signalleitung 10 der Aufsetzstruktur kontaktiert wird.

Wie dies aus Figur 4 hervorgeht, die die Aufsetzstruktur in einer Draufsicht zeigt, weist die Aufsetzstruktur ebenfalls einen teilumfangförmige Struktur 9 (Masse) und eine Signalleitung 10 auf. Die Signalleitung 10 endet in dem Bereich, der von der teilumfangförmigen Struktur 9 begrenzt wird. Vorzugsweise liegt das Ende der Signalleitung 10 koaxial zu der teilumfangförmigen Struktur bzw. koaxial zu der gedachten vollumfänglichen Struktur, wie beispielsweise einer Kreis- oder Ringstruktur, von dem die teilumfangförmige Struktur einen Teilabschnitt bildet.

Durch die stufenförmige Ausgestaltung des Endbereichs der Messspitze wird erreicht, dass der Außenleiter 1 nicht mit der Signalleitung 10 der Aufsetzstruktur des Schaltungsträgers bzw. des Prüfobjekts in Kontakt kommt. Mit anderen Worten wird die Messspitze so auf die Aufsetzstruktur aufgesetzt, dass der Aufsetzbereich der Messspitze mit der Masse 9 der Aufsetzstruktur in Kontakt steht und sich der zurückversetzte Bereich des Außenleiters 1 über die Signalleitung 10 hinweg erstreckt, ohne diese zu kontaktieren.

Die Messspitze kann robust ausgeführt werden, so dass vergleichsweise große Kontaktkräfte angewandt werden können, mit denen die Messspitze auf die Aufsetzstruktur aufgedrückt wird. Dies erlaubt einen automatisierten Messprozess ohne die Gefahr der Beschädigung der Messspitze. Darüber hinaus ermöglicht die Form der Messspitze sowie der Aufsetzstruktur Messungen, die vergleichsweise unempfindlich gegen laterale Verschiebungen bzw. Fehlpositionierungen der Messspitze sind.

Figur 2 zeigt die Messspitze mit einem Leitelastomer 5, das zwischen Ende der Messspitze und dem Prüfobjekt angeordnet ist. Diese Leitelastomer 5 weist elektrisch leitende Partikel auf, die im nicht druckbelasteten Zustand des Leitelastomers 5 voneinander beabstandet sind, so dass das Leitelastomer 5 als Isolator wirkt. Bei Überschreiten einer bestimmten Kontaktkraft bzw. Presskraft wird das Leitelastomer 5 soweit zusammengepresst, dass diese Partikel miteinander in Kontakt treten, so dass eine leitende Verbindung in Wirkrichtung der Presskraft, aber nicht quer dazu erhalten wird. Das Leitelastomer bringt den Vorteil mit sich, dass eine besonders zuverlässige Kontaktierung auch bei unebenen Aufsetzstrukturen ermöglicht wird.

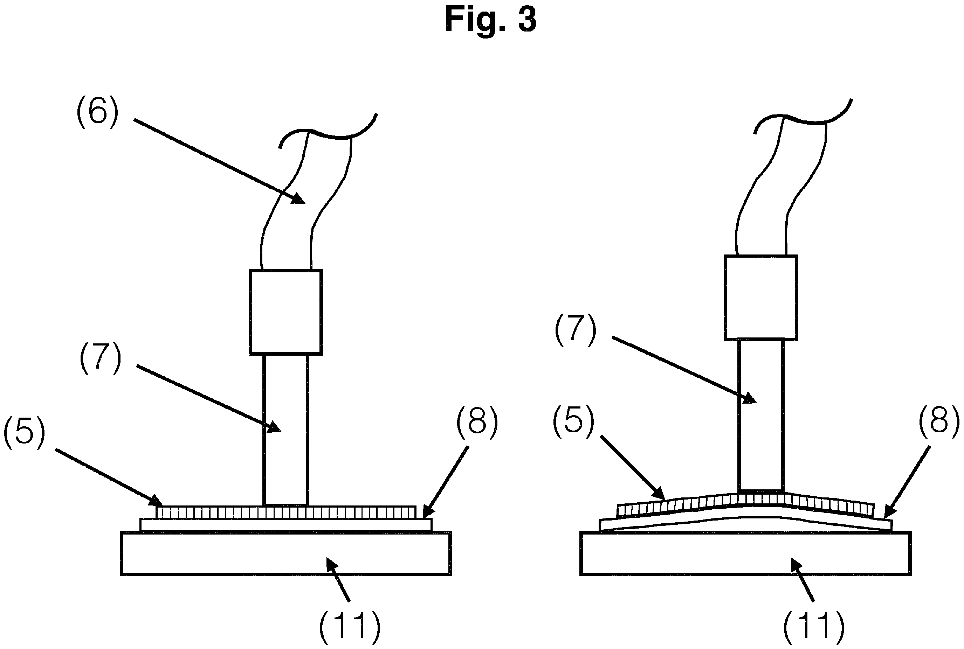

Figur 3, linke Darstellung zeigt die auf das Prüfobjekt 8 aufgesetzte Messspitze 7 mit Kabel 6, mit dem die Messspitze 7 mit einer Vorrichtung zur HF-Messung elektrisch in Verbindung steht. Bei dem Prüfobjekt 8 kann es sich beispielsweise um eine Leiterplatte handeln. Diese ist in der Ausführungsform gemäß Figur 3, linke dargestellt eben und in der Ausführungsform gemäß Figur 3, rechte Darstellung gewölbt.

Das Bezugszeichen 11 kennzeichnet die Auflage, auf der die Leiterplatte 8 aufliegt. Dazwischen befinden sich vorzugsweise ein oder mehrere Kraftmesseinrichtungen. Grundsätzlich ist es auch denkbar, dass die Auflage selbst teilweise oder vollständig die Kraftmesseinrichtung bildet oder aufweist.

Zur vorzugsweise automatisierten HF-Messung der Leiterplatte 8 oder eines sonstigen Prüfobjekts wird die Messspitze 7 zunächst in Bereich der Aufsetzstruktur des Prüfobjekts verfahren und durch elektrische Nahfeldmessungen vor dem Aufsetzen an verschiedenen Positionen wird die laterale Feinpositionierung der Messspitze 7 vorgenommen. Die dabei gemessenen Parameter können beispielsweise Parameter eines Zeitsignals, die Phase oder Streuparameter oder daraus abgeleitete Parameter darstellen. Ist hinsichtlich der gemessenen Werte ein zulässiger bzw. ein optimaler Bereich bzw. Wert gefunden, wird die Messspitze auf die Aufsetzstruktur aufgesetzt.

Das Auffinden der Zielposition erfolgt in diesem Fall somit ohne Kontakt zwischen der Messspitze und der Aufsetzstruktur.

Grundsätzlich ist es auch möglich, die Messspitze wiederholt im Bereich der Aufsetzstruktur auf das Prüfobjekt aufzusetzen und z.B. durch Reflektometrie die Zielposition zu ermitteln. Ist diese Zielposition aufgefunden worden, kann die Messspitze in der zuletzt aufgesetzten Position verbleiben und die Messung beginnen.

Die Messung der zum Auffinden der Zielposition erforderlichen Parameter erfolgt vorzugsweise durch die Messspitze selbst, die bereits mit einem Messgerät verbunden ist.

Vorzugsweise ist somit zum Auffinden der Zielposition weder eine Bilderkennung, noch eine sonstige Sensorik erforderlich. Vielmehr erfolgt das Auffinden der Zielposition vorzugsweise vollautomatisch und allein mittels der durch die Messspitze gemessenen Parameterwerte.

Dazu ist eine Positioniervorrichtung vorhanden, die vollautomatisch die Positionierung der Messspitze in die Zielposition und das Aufsetzen der Messspitze durchführt.

Die Vorteile der vorliegenden Erfindung lassen sich gemäß einer bevorzugten Ausgestaltung wie folgt zusammenfassen:
Die Ausführung der Messspitze ist mechanisch robust sowie HF-tauglich und kann daher in einer rauen Fertigungsumgebung eingesetzt werden. Eine Automatisierung des Messvorgangs ist möglich, auf den Einsatz von händisch zu betätigenden Manipulatoren kann verzichtet werden.

Die Ausformung der Messspitze und des Aufsetzbereichs ist einfach skalierbar, d.h. an benötigte Frequenzbereiche anpassbar.

Die Kalibrierung mit Referenzebene zwischen der Messspitze und der Aufsetzstruktur ist durch geeignete, auch koaxiale Kalibrierstandards möglich.

Wie bereits oben ausgeführt, findet das Messverfahren und insbesondere das Auffinden der Zielposition vorzugsweise automatisiert statt. Dabei bestehen geringe Anforderungen an die Bewegungsachsen und die Lokalisierung der Aufsetzstruktur, wodurch sich ein günstiger Gesamtaufbau der Messvorrichtung insgesamt ergibt.

Die Kraftmessung zwischen dem Prüfobjekt und der Auflage ersetzt eine Sensorik zur Bestimmung der Aufsetzhöhe und sorgt unabhängig von der Höhe und eventuellen Wölbung (vgl. Figur 3, rechte Darstellung) für gleiche Kontaktkräfte auch an mehreren Messstellen, d.h. Aufsetzstrukturen. Aufgrund der Robustheit der Messspitze und Aufgrund der Überwachung der Kraftmessung kann der Aufsetzvorgang und auch der Messvorgang sehr schnell erfolgen.

Durch die genannte Nahfeldmessung ohne Aufsetzen bzw. durch die Reflektometrie mit Aufsetzen der Messspitze kann die Feinpositionierung der Messspitze ohne zusätzliche Hardware erfolgen.

Die Kontaktkraft, mit der die Messspitze auf die Aufsetzstruktur aufgesetzt wird, kann so eingestellt werden, dass Störeinflüsse durch das Kabel der Messspitze oder durch mechanische Spannungen im Prüfobjekt keine Rolle spielen, so dass eine zuverlässige und sichere Kontaktierung erfolgt.

Durch den Einsatz von Leitelastomeren oder elastischen Strukturen der Messspitze können lokale Unebenheiten ausgeglichen werden. Dies ist insbesondere bei dreidimensionalen Schaltungsträgern von Vorteil, die ggf. nicht planare Aufsetzstrukturen aufweisen.

Durch die Kraftmessung zwischen dem Prüfobjekt und dessen Auflage kann die jeweilige Kontaktkraft für eine einzelne Messstelle sowie auch für mehrere Messstehen gesondert erfasst werden, so dass auch im Falle mehrerer Messstellen jeweils ein geeigneter Wert für die Kontaktkraft eingestellt werden kann.

Ein weiterer Vorteil besteht darin, dass die verwendete Aufsetzstruktur wesentlich geringere Anforderungen an den Herstellstellprozess stellt, als die aus dem Stand der Technik bekannten Koplanarstrukturen. Die erfindungsgemäßen Aufsetzstrukturen sind vergleichsweise unempfindlich gegenüber Fertigungstoleranzen und insbesondere unempfindlich gegenüber der Position der Durchkontaktierungen zur Kupferstruktur auf den Leiterplatten.

Wie bereits oben ausgeführt, wird das Messergebnis durch eine laterale Fehlpositionierung der Messspitze nicht oder weniger stark beeinflusst, was wiederum den Vorteil mit sich bringt, dass weniger präzise Positioniersysteme benötigt werden.

Ein weiterer Vorteil besteht darin, dass eine etwaige Wölbung des Schaltungsträgers und die daraus resultierende elastische Verformung des Schaltungsträgers durch Aufsetzen einer Messspitze nicht zu einer Zerstörung einer anderen, bereits aufgesetzten Messspitze führt.

Im Übrigen unterliegt die Kraftmessung nicht dem Einfluss des oder der Messkabel, mit denen die Messspitze verbunden ist, wodurch keine hohe Anforderung an die Präzision der Hubachse gestellt werden muss. Die Kraftmessung und -einstellung gewährleistet einen geringen Verschleiß der Messspitze.

Die Messspitze ist kostengünstig zu fertigen und ist aufgrund ihrer Robustheit in einem Fertigungsumfeld einsetzbar und ermöglicht dadurch eine rückgekoppelte Fertigung.

Durch Verringerung des Ausschusses und der QS-Quote bei gleichzeitiger Erhöhung der Qualität wegen geringer Genauigkeitsanforderungen sind günstigere Positioniersysteme einsetzbar.

Wird das Verfahren automatisiert durchgeführt, spart dies Zeit und Personalkosten, der geringere Verschleiß der Messspitzen führt zu einer Verringerung der Wartungszeiten und -kosten.

Die erfindungsgemäße Messspitze ist vorzugsweise für den automatisierten Einsatz verwendbar, allerdings ist auch eine manuelle Anwendung mittels eines Manipulators nicht ausgeschlossen und von der Erfindung umfasst.

Anwendungsbeispiele sind ein halbautomatischer Messplatz im Labor, ein automatischer Messplatz zur Qualitätssicherung von unbestückten Schaltungsträgern (Ersatz DC-Verbundtest), ein Einsatz in einer Fertigungsumgebung zur Überwachung von Prozess- oder Zielparametern, die rückgekoppelte Fertigung mit ohnehin selektiv arbeitenden additiven oder ablativen Fertigungsverfahren für den Schaltungsträger sowie der Funktionstest oder die Qualitätskontrolle, z.B. einer Stoßstange mit (aufgedruckter) Radarantenne.

Durch die vorliegende Erfindung ist es möglich, eine Messung, insbesondere eine HF-Messung an einem Schaltungsträger schnell und zuverlässig und mit geringem apparativem Aufwand durchzuführen.

## Patentansprüche

1. Vorrichtung zur Kontaktierung eines elektronischen oder elektrischen Systems, insbesondere zur Kontaktierung eines Schaltungsträgers, wobei die Vorrichtung wenigstens eine Messspitze aufweist oder aus dieser besteht, die zum Zwecke einer Messung auf wenigstens eine Aufsetzstruktur des elektronischen oder elektrischen Systems aufsetzbar ist, wobei die Messspitze wenigstens einen Außenleiter (1) und wenigstens einen Innenleiter (2) aufweist, der von dem Außenleiter umgeben ist, wobei sich zwischen dem Außenleiter und dem Innenleiter wenigstens ein Dielektrikum (3) befindet und wobei die Messspitze wenigstens einen endseitigen Aufsetzbereich aufweist, mittels dessen die Messspitze auf die Aufsetzstruktur des Systems aufsetzbar ist, wobei der Aufsetzbereich nur einen Teilbereich der endseitigen Fläche des Außenleiters umfasst, wobei weiterhin die Messspitze endseitig einen vorspringenden und einen demgegenüber zurückversetzten Abschnitt aufweist, **dadurch gekennzeichnet, dass** der vorspringende Abschnitt den Aufsetzbereich des Außenleiters darstellt, ein Teilbereich des stirnseitigen Endes des Außenleiters den Aufsetzbereich des Außenleiters bildet und der Aufsetzbereich des Außenleiters teilumfangförmig ausgeführt ist.

2. Vorrichtung nach Anspruch 1, wobei der Außenleiter und der Innenleiter koaxial angeordnet sind.

3. Vorrichtung nach einem der vorhergehenden Ansprüche, **dadurch gekennzeichnet, dass** der Außenleiter rohrförmig ausgebildet ist und den Innenleiter vollumfänglich umgibt und/oder dass der Aufsetzbereich des Außenleiters teilkreisförmig ausgeführt ist.

4. Vorrichtung nach einem der vorhergehenden Ansprüche, **dadurch gekennzeichnet, dass** der Aufsetzbereich der Messspitze mit wenigstens einem Leitelastomer (5) und/oder mit einem oder mehreren Federkontaktstiften versehen ist

5. Elektronisches oder elektrisches System, insbesondere Schaltungsträger, **dadurch gekennzeichnet, dass** das System wenigstens eine Messspitze einer Vorrichtung gemäß einem der Ansprüche 1 bis 4 und wenigstens eine Aufsetzstruktur aufweist, die ausgebildet ist, mit der Messspitze zusammenzuwirken, wobei die Aufsetzstruktur wenigstens einen teilumfänglichen, vorzugsweise teilkreisförmigen Massebereich sowie wenigstens einen Signalleiter aufweist.

6. System nach Anspruch 5, **dadurch gekennzeichnet, dass** der Signalleiter ein Ende aufweist, das im Zentrum des teilumfänglichen Massebereichs angeordnet ist und/oder **dadurch gekennzeichnet, dass** die Aufsetzstruktur mit wenigstens einem Leitelastomer versehen ist.

7. System nach einem der Ansprüche 5 oder 6, **dadurch gekennzeichnet, dass** das System und/oder dessen Aufsetzstruktur uneben ist und/oder dass das System durch das lagenfreie Erzeugen wenigstens einer räumlichen Struktur unter Verwendung wenigstens eines additiven und/oder abrasiven Verfahrens hergestellt ist.

8. Verfahren zur Positionierung und Kontaktierung eines elektronischen oder elektrischen Systems, insbesondere eines Schaltungsträgers, mit einer Messspitze einer Vorrichtung gemäß einem der Ansprüche 1 bis 4 zur Durchführung einer Messung, insbesondere einer HF-Messung, wobei der Schaltungsträger wenigstens eine Aufsetzstruktur aufweist, auf die die Messspitze aufzusetzen ist, **dadurch gekennzeichnet, dass** das Verfahren den Schritt der lateralen Feinpositionierung der Messspitze durch Messung wenigstens eines Parameters an unterschiedlichen Positionen der Messspitze relativ zu der Aufsetzstruktur sowie die Ermittlung einer Zielposition umfasst, an der der Parameter einen geeigneten oder optimalen Wert annimmt, und wobei das Verfahren des Weiteren den Schritt des Aufsetzens oder des Verbleibens der Messspitze auf die/der Aufsetzstruktur in der Zielposition der Messspitze umfasst.

9. Verfahren nach Anspruch 8, **dadurch gekennzeichnet, dass** es sich bei dem Parameter um die Phase oder wenigstens einen Streuparameter eines gemessenen Signals handelt und/oder dass es sich bei der Messung um eine Nahfeldmessung vor dem Aufsetzen der Messspitze handelt und/oder **dadurch gekennzeichnet, dass** das Verfahren automatisiert durchgeführt wird.

10. Verfahren nach einem der Ansprüche 8 oder 9, **dadurch gekennzeichnet, dass** die Messung das wiederholte Aufsetzen der Messspitze und das Messen des Parameterwertes bei aufgesetzter Messspitze umfasst und/oder **dadurch gekennzeichnet, dass** mittels der Messspitze elektromagnetische Wellen geführt werden.

11. Verfahren nach einem der Ansprüche 8 bis 10, **dadurch gekennzeichnet, dass** die Messspitze als dielektrischer Wellenleiter oder als Hohlleiter oder als Mehrleiteranordnung ausgebildet ist, wobei vorzugsweise vorgesehen ist, dass die Mehrleiteranordnung einen oder mehrere Signalleiter und einen oder mehrere Masse- leiter umfassst oder aus diesen besteht.

12. Verfahren nach einem der Ansprüche 8 bis 11, **dadurch gekennzeichnet, dass** es sich bei der Messspitze um die Messspitze einer Vorrichtung gemäß einem der Ansprüche 1 bis 4 handelt und/oder dass es sich bei dem System um ein elektronisches oder elektrisches System nach einem der Ansprüche 5 bis 7handelt.

13. Verfahren zur Kontaktierung eines elektronischen oder elektrischen Systems, insbesondere eines Schaltungsträgers, mit einer Messspitze einer Vorrichtung gemäß einem der Ansprüche 1 bis 4 zur Durchführung einer Messung, insbesondere einer HF-Messung, wobei der Schaltungsträger wenigstens eine Aufsetzstruktur aufweist, auf die die Messspitze aufzusetzen ist, **dadurch gekennzeichnet, dass** das Verfahren den Schritt der Messung der Kraft umfasst, mit der die Messspitze die Aufsetzstruktur kontaktiert, wobei die Messung durch wenigstens eine Messvorrichtung vorgenommen wird, die sich zwischen dem System und wenigstens einer Systemaufnahme befindet, auf der das System angeordnet ist.

14. Verfahren nach Anspruch 13, **dadurch gekennzeichnet, dass** wenigstens drei Messvorrichtungen sowie mehrere Aufsetzstrukturen des Systems vorgesehen sind und dass zumindest eine Recheneinheit vorgesehen ist, die aus den durch die Messvorrichtungen gemessenen Werten sowie aus den bekannten Positionen der Aufsetzstrukturen die Einzelkräfte bestimmt, mit denen die einzelnen Messspitzen die jeweilige Aufsetzstruktur kontaktieren.

15. Vorrichtung mit Mitteln zur Durchführung eines Verfahrens gemäß einem der Ansprüche 8 bis 14.

## Claims

1. Device for making contact with an electronic or electric system, in particular for contacting a circuit carrier, wherein the device consists of or comprises at least one measuring tip which can be placed on at least one place-on structure of the electronic or electric system for the purpose of a measurement, wherein the measuring tip comprises at least one outer conductor (1) and at least one inner conductor (2) which is surrounded by the outer conductor, wherein at least one dielectric (3) is located between the outer conductor and the inner conductor, and wherein the measuring tip comprises at least one end-side place-on region, by means of which the measuring tip can be placed onto the place-on structure of the system, wherein the place-on region comprises only a partial region of the end-side face of the outer conductor, wherein the measuring tip further comprises a projecting portion at the end and a portion which is recessed relative to the projecting portion, **characterized in that** the projecting portion constitutes the place-on region of the outer conductor, a partial region of the face-side end of the outer conductor forms the place-on region of the outer conductor and the place-on region of the outer conductor is partially circumferential.

2. Device according to claim 1, wherein the outer conductor and the inner conductor are arranged coaxially.

3. Device according to any one of the preceding claims, **characterized in that** the outer conductor is of tubular design and completely surrounds the inner conductor and/or **in that** the place-on region of the outer conductor is of pitch-circle design.

4. Device according to any one of the preceding claims, **characterized in that** the place-on region of the measuring tip is provided with at least one conductive elastomer (5) and/or with one or more spring-loaded pins.

5. Electronic or electric system, in particular circuit carrier, **characterized in that** the system comprises at least one measuring tip of a device according to any one of claims 1 to 4 and at least one place-on structure which is configured to interact with the measuring tip, wherein the place-on structure comprises at least one partly circumferential, preferably partially circular ground region and at least one signal conductor.

6. System according to claim 5, **characterized in that** the signal conductor has an end which is arranged in the center of the partly circumferential ground region and/or **characterized in that** the place-on structure is provided with at least one conductive elastomer.

7. System according to any one of claims 5 or 6, **characterized in that** the system and/or its place-on structure is uneven and/or that the system is produced by the layer-free creation of at least one physical structure using at least one additive and/or abrasive process.

8. Method for positioning and contacting an electronic or electric system, in particular a circuit carrier, having a measuring tip of a device according to any one of claims 1 to 4 for carrying out a measurement, in particular an RF measurement, wherein the circuit carrier has at least one place-on structure on which the measuring tip is to be placed, **characterized in that in that** the method comprises the step of lateral fine positioning of the measuring tip by measuring at least one parameter at different positions of the measuring tip relative to the place-on structure and determining a target position at which the parameter assumes a suitable or optimum value, and wherein the method further comprises the step in which the measuring tip is placed on or remains on the place-on structure(s) in the target position of the measuring tip.

9. Method according to claim 8, **characterized in that** the parameter is the phase or at least one scattering parameter of a measured signal and/or that the measurement is a near-field measurement before placing-on of the measuring tip and/or **characterized in that** the method is carried out automatedly

10. Method according to any one of claims 8 or 9, **characterized in that** the measurement comprises the repeated placement of the measuring tip and measuring of the parameter value with the placed-on measuring tip and/or **characterized in that** electromagnetic waves are guided by means of the measuring tip.

11. Method according to any one of claims 8 to 10, **characterized in that** the measuring tip is configured as a dielectric waveguide or as a hollow conductor or as a multi-conductor assembly, wherein it is preferably provided that the multi-conductor assembly comprises or consists of one or more signal conductors and one or more earth conductors.

12. Method according to any one of claims 8 to 11, **characterized in that** the measuring tip is the measuring tip of a device according to any one of claims 1 to 4 and/or that the system is an electronic or electric system according to any one of claims 5 to 11.

13. Method for making contact with an electronic or electric system, in particular a circuit carrier, with a measuring tip of a device according to any one of claims 1 to 4 for performing a measurement, in particular an RF measurement, wherein the circuit carrier has at least one place-on structure on which the measuring tip is to be placed, **characterized in that** the method comprises the step of measuring the force with which the measuring tip contacts the place-on structure, wherein the measurement is carried out by at least one measuring device which is located between the system and at least one system receptacle, on which the system is arranged.

14. Method according to claim 13, **characterized in that** at least three measuring devices and a plurality of place-on structures of the system are provided and **in that** at least one computing unit is provided which determines the individual forces with which the individual measuring tips contact the respective place-on structure from the values measured by the measuring devices and from the known positions of the place-on structures.

15. Device comprising means for carrying out a method according to any one of claims 8 to 14.

## Revendications

1. Dispositif de mise en contact d'un système électronique ou électrique, notamment pour la mise en contact d'un support de circuit, le dispositif présentant ou étant constitué d'au moins une pointe de mesure, qui peut être posée sur au moins une structure de pose du système électronique ou électrique en vue d'une mesure, la pointe de mesure présentant au moins un conducteur extérieur (1) et au moins un conducteur intérieur (2) qui est entouré par le conducteur extérieur, au moins un diélectrique (3) se trouvant entre le conducteur extérieur et le conducteur intérieur, et la pointe de mesure présentant au moins une zone de pose d'extrémité, au moyen de laquelle la pointe de mesure peut être posée sur la structure de pose du système, la zone de pose ne comprenant qu'une zone partielle de la surface d'extrémité du conducteur extérieur, la pointe de mesure présentant en outre à l'extrémité une section en saillie et une section en retrait par rapport à celle-ci, **caractérisé en ce que** la section en saillie représente la zone de pose du conducteur extérieur, une zone partielle de l'extrémité frontale du conducteur extérieur forme la zone de pose du conducteur extérieur et la zone de pose du conducteur extérieur est réalisée en forme de circonférence partielle.

2. Dispositif selon la revendication 1, dans lequel le conducteur extérieur et le conducteur intérieur sont agencés coaxialement.

3. Dispositif selon l'une quelconque des revendications précédentes, **caractérisé en ce que** le conducteur extérieur est configuré sous forme tubulaire et entoure entièrement le conducteur intérieur et/ou **en ce que** la zone de pose du conducteur extérieur est réalisée sous forme partiellement circulaire.

4. Dispositif selon l'une quelconque des revendications précédentes, **caractérisé en ce que** la zone de pose de la pointe de mesure est pourvue d'au moins un élastomère conducteur (5) et/ou d'une ou plusieurs broches de contact à ressort.

5. Système électronique ou électrique, notamment support de circuit, **caractérisé en ce que** le système présente au moins une pointe de mesure d'un dispositif selon l'une quelconque des revendications 1 à 4 et au moins une structure de pose configurée pour coopérer avec la pointe de mesure, la structure de pose présentant au moins une zone de masse partiellement périphérique, de préférence en forme de cercle partiel, ainsi qu'au moins un conducteur de signaux.

6. Système selon la revendication 5, **caractérisé en ce que** le conducteur de signaux présente une extrémité agencée au centre de la zone de masse partiellement circonférentielle et/ou **caractérisé en ce que** la structure de pose est munie d'au moins un élastomère conducteur.

7. Système selon l'une quelconque des revendications 5 ou 6, **caractérisé en ce que** le système et/ou sa structure de pose sont inégaux et/ou **en ce que** le système est fabriqué par la création sans couche d'au moins une structure spatiale en utilisant au moins un procédé additif et/ou abrasif.

8. Procédé de positionnement et de mise en contact d'un système électronique ou électrique, notamment d'un support de circuit, avec une pointe de mesure d'un dispositif selon l'une quelconque des revendications 1 à 4 pour effectuer une mesure, notamment une mesure HF, le support de circuit présentant au moins une structure de pose sur laquelle la pointe de mesure doit être posée, **caractérisé en ce que** le procédé comprend l'étape de positionnement latéral fin de la pointe de mesure par mesure d'au moins un paramètre à différentes positions de la pointe de mesure par rapport à la structure de pose, ainsi que la détermination d'une position cible à laquelle le paramètre prend une valeur appropriée ou optimale, et le procédé comprenant en outre l'étape de pose ou de maintien de la pointe de mesure sur la structure de pose dans la position cible de la pointe de mesure.

9. Procédé selon la revendication 8, **caractérisé en ce que** le paramètre consiste en la phase ou au moins un paramètre de dispersion d'un signal mesuré et/ou **en ce que** la mesure consiste en une mesure de champ proche avant la pose de la pointe de mesure et/ou **caractérisé en ce que** le procédé est effectué de manière automatisée.

10. Procédé selon l'une quelconque des revendications 8 ou 9, **caractérisé en ce que** la mesure comprend la pose répétée de la pointe de mesure et la mesure de la valeur du paramètre lorsque la pointe de mesure est posée et/ou **caractérisé en ce que** des ondes électromagnétiques sont guidées au moyen de la pointe de mesure.

11. Procédé selon l'une quelconque des revendications 8 à 10, **caractérisé en ce que** la pointe de mesure est configurée sous forme de guide d'ondes diélectrique ou sous forme de conducteur creux ou sous forme d'agencement de plusieurs conducteurs, il étant de préférence prévu que l'agencement de plusieurs conducteurs comprend ou est constitué d'un ou plusieurs conducteurs de signaux et d'un ou plusieurs conducteurs de masse.

12. Procédé selon l'une quelconque des revendications 8 à 11, **caractérisé en ce que** la pointe de mesure consiste en la pointe de mesure d'un dispositif selon l'une quelconque des revendications 1 à 4 et/ou **en ce que** le système consiste en un système électronique ou électrique selon l'une quelconque des revendications 5 à 7.

13. Procédé de mise en contact d'un système électronique ou électrique, notamment d'un support de circuit, avec une pointe de mesure d'un dispositif selon l'une quelconque des revendications 1 à 4 pour effectuer une mesure, notamment une mesure HF, le support de circuit présentant au moins une structure de pose sur laquelle la pointe de mesure doit être posée, **caractérisé en ce que** le procédé comprend l'étape de mesure de la force avec laquelle la pointe de mesure est en contact avec la structure de pose, la mesure étant effectuée par au moins un dispositif de mesure se trouvant entre le système et au moins un réceptacle du système sur lequel le système est agencé.

14. Procédé selon la revendication 13, **caractérisé en ce qu'**il est prévu au moins trois dispositifs de mesure ainsi que plusieurs structures de pose du système et **en ce qu'**il est prévu au moins une unité de calcul qui détermine, à partir des valeurs mesurées par les dispositifs de mesure ainsi qu'à partir des positions connues des structures de pose, les forces individuelles avec lesquelles les pointes de mesure individuelles sont en contact avec la structure de pose respective.

15. Dispositif avec des moyens pour mettre en oeuvre un procédé selon l'une quelconque des revendications 8 à 14.
